# EUROPEAN PATENT SPECIFICATION

(11) **EP 3 828 940 B1**
(45) Date of publication and mention of the grant of the patent: **13.09.2023**
(21) Application number: 18927910.2
(22) Date of filing: 24.07.2018
(51) Int. Cl.: H01L 33/00, H01L 33/62, H05K 13/04

(54) **COMPONENT MOUNTING METHOD AND WORK SYSTEM**
KOMPONENTENMONTAGEVERFAHREN UND ARBEITSSYSTEM
PROCÉDÉ DE MONTAGE DE COMPOSANTS ET SYSTÈME DE TRAVAIL

(43) Date of publication of application: 02.06.2021
(73) Proprietor: Fuji Corporation, Chiryu-shi, Aichi 472-8686 (JP)
(72) Inventor: SAKURAYAMA, Takeshi, Chiryu-shi, Aichi 472-8686 (JP)
(74) Representative: Grünecker Patent- und Rechtsanwälte PartG mbB
(86) International application number: PCT/JP2018/027623
(87) International publication number: WO 2020/021617

(56) References cited:
- JP-A- 2006 165 141
- JP-A- 2016 157 898
- US-A1- 2015 364 384
- US-A1- 2016 254 427
- US-A1- 2016 255 752

## Description

### Technical Field

The present invention relates to a component mounting method for mounting a surface mount type LED on a board, and a work system thereof.

### Background Art

The following Patent Literatures disclose a technique of mounting a surface mount type LED on a board.

US 2016/255752 A1 relates to mounting LED components on a board in with increased accuracy regarding the position of the component towards the board. Adhesive spots are applied along a symmetry axis through the center of the LED and cured at a temperature lower than the curing temperature of the solder paste.

### Patent Literature

Patent Literature 1: JP-A-2016-181723
Patent Literature 2: JP-A-2012-238411

### Summary of the invention

### Technical Problem

A problem is to appropriately mount a surface mount type LED on a board.

### Solution to Problem

The invention is defined by the features of the independent claims. Any reference to inventions or embodiments not falling within the scope of the independent claims are to be interpreted as examples useful for understanding the invention.

In order to solve the above problem, the present specification discloses a component mounting method for mounting a surface mount type LED on a board, the method comprising: a solder coating step of coating a solder paste to the board; an adhesive coating step of coating an adhesive to the board so that an inclination of the surface mount type LED with respect to the board, the inclination of which being caused by reflow, is prevented when the surface mount type LED is mounted on the board; an imaging step of imaging, from above, the surface mount type LED before being mounted, so as to acquire imaging data; a calculating step of calculating a position of a light emitting region of the surface mount type LED based on the imaging data; a mounting step of mounting the surface mount type LED on the board via the solder paste and the adhesive based on the position of the light emitting region calculated by the calculating step; and a reflow step of applying the reflow to the board, on which the surface mount type LED is mounted.

According to the inventon, the adhesive is discharged to four corners of the planned mounting positions of the surface mount type LED, so that amounts of the adhesive are equal to each other, and such as not to overlap with the solder paste.

In addition, the present specification discloses a work system including: a mounting device configured to mount a surface mount type LED on a board; a first coating device configured to coat a solder paste to the board; a second coating device configured to coat an adhesive to the board; an imaging device; a reflow device configured to allow the board to reflow; and a control device, in which the control device includes: a solder coating section configured to coat the solder paste to the board by the first coating device, an adhesive coating section configured to coat the adhesive to the board by the second coating device so that an inclination of the surface mount type LED with respect to the board, the inclination of which being caused by the reflow, is prevented when the surface mount type LED is mounted on the board, an imaging section configured to image, by the imaging device from above, the surface mount type LED before mounting, to acquire imaging data, a calculating section configured to calculate a position of a light emitting region of the surface mount type LED based on the imaging data, a mounting section configured to mount the surface mount type LED on the board via the solder paste and the adhesive by the mounting device based on the position of the light emitting region calculated by the calculating section, and a reflow section configured to apply the reflow by the reflow device to the board, on which the surface mount type LED is mounted.

According to the invention, the adhesive coating section is further configured to discharge the adhesive to four corners of the planned mounting positions of the surface mount type LED, so that amounts of the adhesive are equal to each other, and such as not to overlap with the solder paste.

### Advantageous Effect of the Invention

According to the present invention, the solder paste is coated to the board, and the adhesive is coated to the board, whereby the adhesive is discharged to four corners of the planned mounting positions of the surface mount type LED so that amounts of the adhesive are equal to each other, and such as not to overlap with the solder paste, so that an inclination of the surface mount type LED with respect to the board, the inclination of which being caused by reflow, can be prevented in a case where the surface mount type LED is mounted on the board via the solder paste. Therefore, it is possible to appropriately mount the surface mount type LED on the board.

### Brief Description of Drawings

Fig. 1 is a plan view illustrating an electronic component mounting system.
Fig. 2 is a block diagram illustrating a control device.
Fig. 3 is a plan view illustrating an LED package.
Fig. 4 is a sectional view in line AA of Fig. 3.
Fig. 5 is a view illustrating an adhesive discharged to a circuit board.
Fig. 6 is a plan view illustrating the LED package.
Fig. 7 is a plan view illustrating the LED package fixed by the adhesive in accordance with the component mounting method of the invention.
Fig. 8 is a plan view illustrating an LED package of a modification example fixed by an adhesive in accordance with an illustrative example not in accordance with the component mounting method of the invention.
Fig. 9 is a plan view illustrating an LED package of a modification example fixed by an adhesive in accordance with an illustrative example not in accordance with the component mounting method of the invention.

### Description of Embodiments

Hereinafter, as forms for carrying out the present invention, examples of the present invention and examples not forming part of the invention but useful for understanding the invention are described in detail referring to drawings.

### (A) Configuration of Electronic Component Mounting System

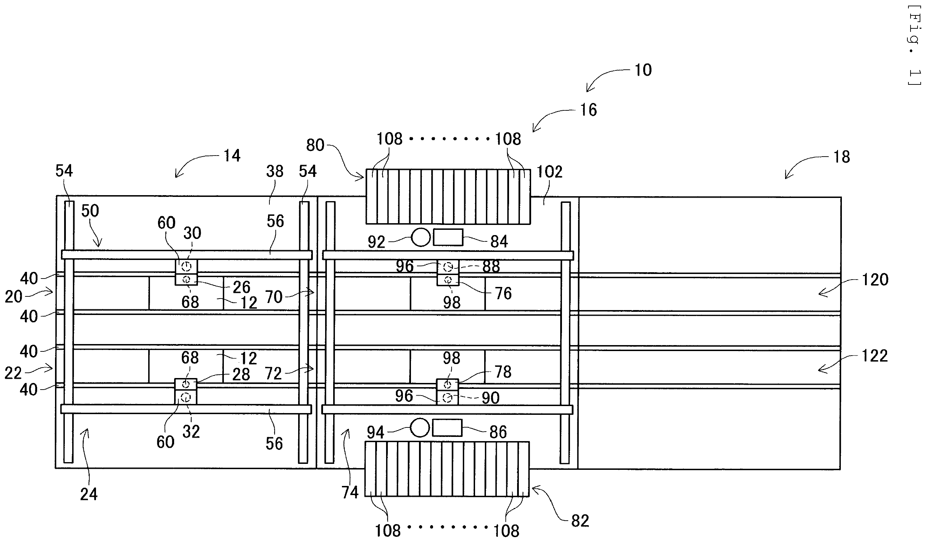

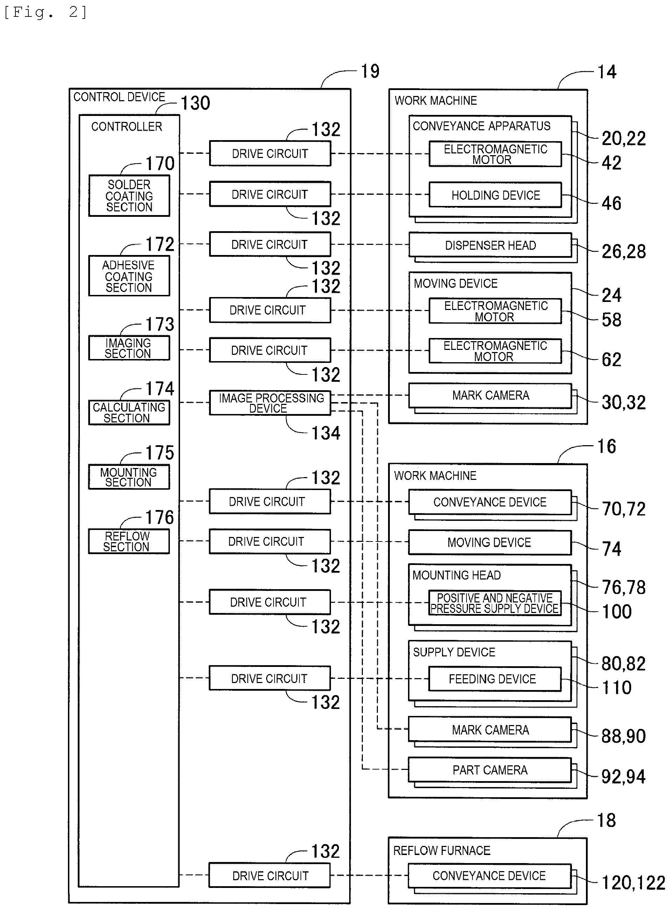

Fig. 1 illustrates electronic component mounting system 10 according to an example. Electronic component mounting system 10 performs a mounting operation of an electronic component such as an LED package on circuit board 12, and includes two work machines 14 and 16, reflow furnace 18, and control device (see Fig. 2) 19. Two work machines 14 and 16, and reflow furnace 18 are arranged in a row in a state of being adjacent to each other the order of work machine 14, work machine 16, and reflow furnace 18 from an upstream side, work machine 14 and work machine 16 are coupled, and work machine 16 and reflow furnace 18 are coupled. Incidentally, a direction in which two work machines 14 and 16, and reflow furnace 18 are arranged is described as an X-axis direction, and a horizontal direction perpendicular to the X-axis direction is described as a Y-axis direction.

Work machine 14 includes a pair of conveyance devices 20 and 22, moving device 24, a pair of dispenser heads 26 and 28, and a pair of mark cameras 30 and 32.

The pair of conveyance devices 20 and 22 are parallel to each other, and are disposed on base 38 so as to extend in the X-axis direction. The pair of conveyance devices 20 and 22 have the same configuration with each other, and are symmetrically disposed in the Y-axis direction. Each of the pair of conveyance devices 20 and 22 has a pair of conveyor belts 40 extending in the X-axis direction, and electromagnetic motor (see Fig. 2) 42 that rotates conveyor belts 40. Circuit board 12 is supported by a pair of conveyor belts 40 thereof, and is conveyed in the X-axis direction by the drive of electromagnetic motor 42. Further, each of the pair of conveyance devices 20 has holding device (see Fig. 2) 46. Holding device 46 fixedly holds, at a predetermined position, circuit board 12 supported by conveyor belt 40.

Moving device 24 is constituted by X-axis direction slide mechanism 50 and Y-axis direction slide mechanism 52. Y-axis direction slide mechanism 52 has a pair of Y-axis direction guide rails 54 extending in the Y-axis direction. On the other hand, X-axis direction slide mechanism 50 has a pair of X-axis direction guide rails 56 extending in the X-axis direction. The pair of X-axis direction guide rails 56 are overlaid on the pair of Y-axis direction guide rails 54. Y-axis direction slide mechanism 52 has electromagnetic motor (see Fig. 2) 58, and each X-axis direction guide rail 56 is moved to any position in the Y-axis direction by the drive of electromagnetic motor 58. Each X-axis direction guide rail 56 holds slider 60 so as to be movable along its own axis. X-axis direction slide mechanism 50 has electromagnetic motor (see Fig. 2) 62, and each slider 60 is moved to any position in the X-axis direction by the drive of electromagnetic motor 62. Dispenser heads 26 and 28 are attached to slider 60. With such a structure, dispenser heads 26 and 28 are moved to any position on base 38 by moving device 24.

Each of the pair of dispenser heads 26 and 28 discharges a viscous fluid from nozzle port 68 formed on a lower surface. Dispenser head 26 is filled with a solder paste as a viscous fluid, and dispenser head 28 is filled with an adhesive as a viscous fluid. Therefore, dispenser head 26 discharges the solder paste, and dispenser head 28 discharges the adhesive. As the adhesive, a thermosetting resin which cures at a temperature lower than a melting point of the solder paste is adopted. That is, the curing temperature of the adhesive is lower than a melting point of the solder paste.

The pair of mark cameras 30 and 32 are attached to the pair of sliders 60 of moving device 24 in a state of facing downward, and move in the X direction and the Y direction together with dispenser heads 26 and 28. Thus, each of mark cameras 30 and 32 is moved to any position by an operation of moving device 24 to image any position on base 38.

Further, work machine 16 includes a pair of conveyance devices 70 and 72, moving device 74, a pair of mounting heads 76 and 78, a pair of supply devices 80 and 82, a pair of loading tables 84 and 86, a pair of mark cameras 88 and 90, and a pair of part cameras 92 and 94. Conveyance devices 70 and 72 have same structures as those of the conveyance devices 20 and 22 of work machine 14, moving device 74 has a same structure as that of moving device 24 of work machine 14, and mark cameras 88 and 90 have same structures as those of mark camera 30 and 32 of work machine 14. Therefore, the description of conveyance devices 70 and 72, moving device 74, and mark cameras 88 and 90 will be omitted. Incidentally, conveyance devices 70 and 72 are coupled to conveyance devices 20 and 22 of work machine 14.

Mounting heads 76 and 78 are attached to sliders 96 of moving device 74, and have suction nozzles 98 provided on lower end surfaces thereof. Suction nozzle 98 is connected to positive and negative pressure supply device (see Fig. 2) 100. Therefore, suction nozzle 98 sucks and holds the electronic component by using a negative pressure, and separates the electronic component by using a positive pressure.

The pair of supply devices 80 and 82 are disposed on both sides of base 102 in the Y-axis direction so as to sandwich the pair of conveyance devices 70 and 72. Each of supply devices 80 and 82 has tape feeder 108, and tape feeder 108 is housed in a state of winding a taped component. The taped component is obtained by taping the electronic component, and tape feeder 108 feeds the taped component by feeding device (see Fig. 2) 110. Thus, each of supply devices 80 and 82 supplies the electronic components to a supply position by feeding the taped component.

Each of the pair of loading tables 84 and 86 is disposed between conveyance devices 70 and 72, and supply devices 80 and 82. Loading tables 84 and 86 have upper surfaces that are flat surfaces, and it is possible to load components, which are held by mounting heads 76 and 78, on the upper surfaces of the loading tables 84 and 86.

The pair of part cameras 92 and 94 are disposed next to the pair of loading tables 84 and 86 in a state of facing upward. Thus, mounting heads 76 and 78 that hold the components move above part cameras 92 and 94 by an operation of moving device 74, and thereby the part cameras 92 and 94 image the components held by suction nozzles 98.

Further, reflow furnace 18 includes a pair of conveyance devices 120 and 122. Since conveyance devices 120 and 122 have same structures as those of conveyance devices 20 and 22 of work machine 14, the description of the conveyance devices 120 and 122 will be omitted. The conveyance devices 120 and 122 are coupled to conveyance devices 70 and 72 of work machine 16.

Further, as illustrated in Fig. 2, control device 19 includes controller 130, multiple drive circuits 132, and image processing device 134. Multiple drive circuits 132 are connected to dispenser heads 26 and 28 of work machine 14, electromagnetic motors 42, 58, and 62, holding device 46, conveyance devices 70 and 72 of work machine 16, moving device 74, positive and negative pressure supply device 100, feeding device 110, and conveyance devices 120 and 122 of reflow furnace 18. Controller 130 includes CPU, ROM, RAM, and the like, is mainly a computer, and is connected to multiple drive circuits 132. Thus, operations of work machines 14 and 16, and reflow furnace 18 are controlled by controller 130. Further, image processing device 134 processes the imaging data obtained by mark cameras 30, 32, 88, and 90, and part cameras 92 and 94, and controller 130 acquires various information from the imaging data.

### (B) Mounting Operation by Electronic Component Mounting System

In electronic component mounting system 10, a mounting operation of mounting the electronic component on circuit board 12 is performed by the configuration described above. In electronic component mounting system 10, the mounting operation of various electronic components is performed, and the mounting operation of the LED package will be described in detail below.

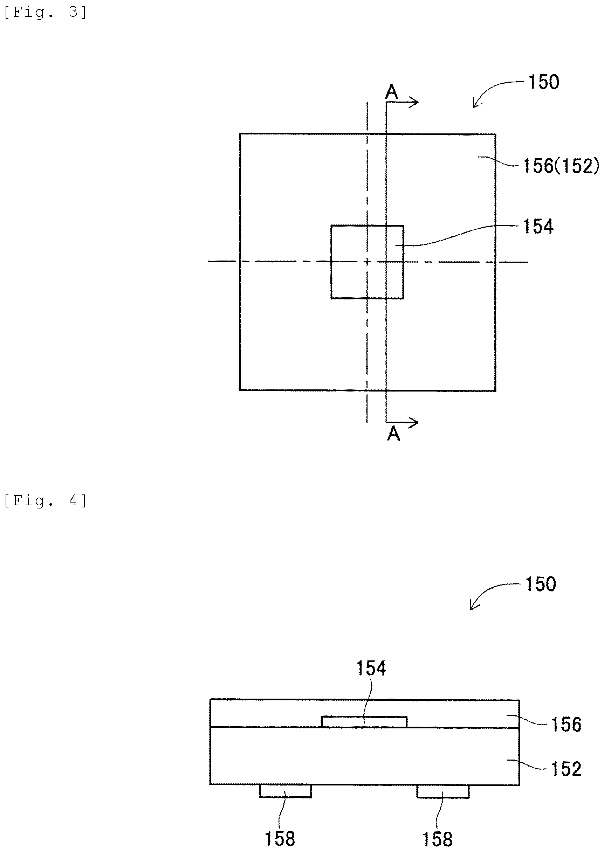

As illustrated in Figs. 3 and 4, LED package 150 includes package board 152, LED element 154, sealing resin 156, and electrodes 158. Fig. 3 is a plan view illustrating LED package 150 in a view from above, and Fig. 4 is a sectional view in line AA of Fig. 3. In LED package 150, LED element 154 is disposed on an upper surface of package board 152, and LED element 154 is sealed by sealing resin 156. Further, electrodes 158 are disposed on a lower surface of package board 152. LED element 154 is disposed in a center of package board 152, and LED element 154 emits light by energization. Light emission by LED element 154 is highly directional and LED package 150 is used as a light source for vehicle lights.

When circuit board 12 of a mounting target of LED package 150 having such a structure is conveyed in work machine 14, conveyance devices 20 and 22 of work machine 14 convey circuit board 12 to an operation position by a command of controller 130, and circuit board 12, at that position, is held by holding device 46. Conveyance devices 20 and 22 of working machine 14 convey circuit board 12 to an operation position by a command of controller 130, and circuit board 12 is held by holding device 46 at that position. Next, moving device 24 moves mark cameras 30 and 32 on circuit board 12 by a command of controller 130, and circuit board 12 is imaged by mark cameras 30 and 32. Based on the imaging data, in controller 130, a holding position error of circuit board 12 by conveyance devices 20 and 22 is calculated.

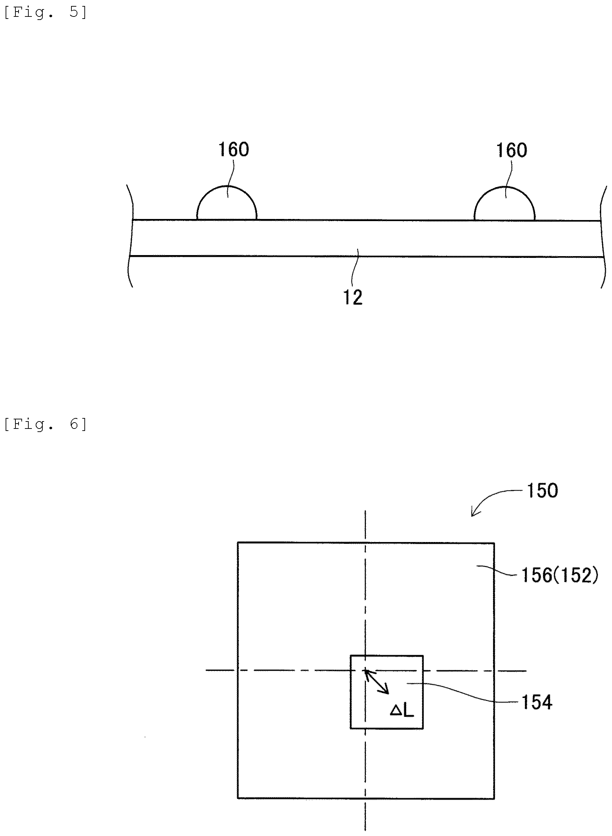

Then, in consideration of the holding position error of circuit board 12, moving device 24 moves dispenser heads 26 and 28, and the solder paste and the adhesive are coated to a planned mounting position of LED package 150. Specifically, the solder paste is discharged by dispenser head 26 at a planned mounting position of the electrode of LED package 150. In addition, and in accordance with the invention, the adhesive is discharged by dispenser head 28 to four corners of the planned mounting positions of LED package 150. At this time, dispenser head 28 discharges the adhesive to the four planned mounting positions of LED package 150 of circuit board 12 so that amounts of the adhesive are equal to each other. Therefore, as illustrated in Fig. 5, heights of adhesive 160 discharged to the four planned mounting positions of LED package 150 are equal to each other. That is, dispenser head 28 discharges adhesive 160 such that the heights of the LED packages 150 at the four planned mounting positions are equal to each other. In Fig. 5, adhesive 160 discharged to two planned mounting positions is illustrated. In addition, dispenser head 28 discharges the adhesive such as not to overlap with the solder paste. That is, dispenser head 28 discharges the adhesive to a point where the solder paste is not discharged. Then, when the solder paste and the adhesive are discharged to the planned mounting positions, circuit board 12 is conveyed out from work machine 14 and conveyed in work machine 16.

Subsequently, when circuit board 12 is conveyed in work machine 16, conveyance devices 70 and 72 of work machine 16 convey circuit board 12 to the operation position by a command of controller 130, and holds circuit board 12 at that position. Next, moving device 74 moves mark cameras 88 and 90 on circuit board 12 by a command of controller 130, and circuit board 12 is imaged by mark cameras 88 and 90. Based on the imaging data, in controller 130, the holding position error of circuit board 12 by conveyance devices 70 and 72 is calculated.

Further, in work machine 16, supply devices 80 and 82 supply LED package 150 at a supply position by a command of controller 130. Then, moving device 74 moves mounting heads 76 and 78 above the supply positions of supply devices 80 and 82 by a command of controller 130, and LED package 150 is sucked and held by suction nozzle 98. Next, moving device 74 moves mounting heads 76 and 78 above loading tables 84 and 86 by a command of controller 130, and LED package 150 held by suction nozzle 98 is placed on loading tables 84 and 86.

When LED package 150 is placed on loading tables 84 and 86, moving device 74 moves mark cameras 88 and 90 above loading tables 84 and 86 by a command of controller 130, and LED package 150 is imaged by mark cameras 88 and 90. Based on the imaging data, in controller 130, a positional deviation amount of LED element 154 in LED package 150 is calculated. Specifically, at a time of manufacture of LED package 150, as illustrated in Fig. 6, LED element 154 may be disposed at a position deviated from the center of package board 152. Then, as described above, since LED package 150 is used as a light source of light, it is necessary to unify the position of LED element 154 that emits light to a predetermined position on circuit board 12. Therefore, in controller 130, deviation amount ΔL of LED element 154 from the center of package board 152 in LED package 150 is calculated.

Next, when LED package 150 is imaged by mark cameras 88 and 90 in the loading tables 84 and 86, moving device 74 moves mounting heads 76 and 78 above loading tables 84 and 86, and LED package 150 is sucked and held by suction nozzle 98. Subsequently, moving device 74 moves mounting heads 76 and 78 in a state of holding LED package 150 above part cameras 92 and 94, and LED package 150 held by mounting heads 76 and 78 is imaged by part cameras 92 and 94. The holding position error of LED package 150 is acquired by the imaging thereof.

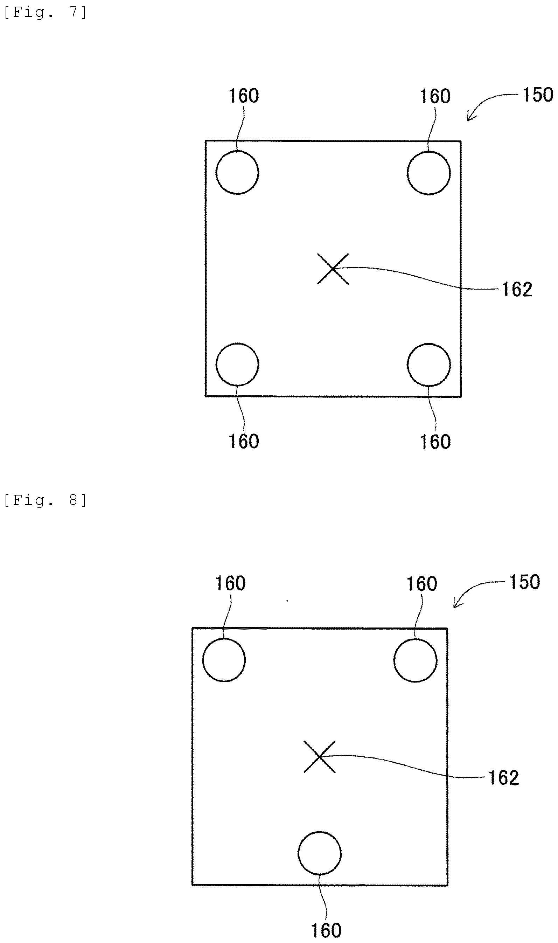

Then, moving device 74 moves mounting heads 76 and 78 above the planned mounting position on circuit board 12 in a state of holding LED package 150, and LED package 150 is mounted on the planned mounting position. At this time, the operation of moving device 74 is controlled based on deviation amount ΔL of LED element 154, the holding position error of circuit board 12, and the holding position error of LED package 150. Thus, even in a case where LED element 154 in LED package 150 is deviated from the center of package board 152, it is possible to unify the position of LED element 154 to a predetermined position on circuit board 12. Further, in LED package 150 mounted on circuit board 12, the solder paste coated to circuit board 12 is in contact with electrodes 158, and as illustrated in Fig. 7, adhesive 160 coated to circuit board 12 is in contact with, in accordance with the invention, the four corners of LED package 150. At this time, the adhesive which is in contact with the four corners of LED package 150 is disposed to surround center 162 of gravity of LED package 150. That is, in electronic component mounting system 10, in work machine 14, adhesive 160 is coated to circuit board 12 so as to surround center 162 of gravity of LED package 150 in a case of being mounted on circuit board 12.

Then, when LED package 150 is mounted on the planned mounting position, circuit board 12 is conveyed out from work machine 16 and is conveyed in reflow furnace 18. When circuit board 12 is conveyed in reflow furnace 18, conveyance devices 120 and 122 of reflow furnace 18 convey circuit board 12 by a command of controller 130. At this time, in reflow furnace 18, circuit board 12 is heated, LED package 150 is soldered by reflow of the paste solder, and LED package 150 is fixed by curing of the adhesive.

Specifically, since the curing temperature of the adhesive is lower than the melting point of the solder paste, in reflow furnace 18, first, the adhesive is cured, and LED package 150 is fixed to circuit board 12 by the cured adhesive. After LED package 150 is fixed by the adhesive, the solder paste is melted, and LED package 150 is soldered to circuit board 12. At this time, there is a possibility that LED package 150 is inclined with respect to circuit board 12 due to the melting of the solder paste. However, when the solder paste is melted, LED package 150 is fixed by the cured adhesive at the four corners surrounding center 162 of gravity, so that the inclination of LED package 150 with respect to circuit board 12 is suppressed. In other words, the discharge amounts of the adhesive discharged to the four corners surrounding center 162 of gravity are**,** in accordance with the invention, equal to each other, and the heights of the adhesives discharged to the four corners are equal to each other. Therefore, the inclination of LED package 150 with respect to circuit board 12 is preferably suppressed. Specifically, at a height from the upper surface of circuit board 12 to the upper surface of LED package 150, a difference between a maximum height and a minimum height is 25µm. Thus, in electronic component mounting system 10, it is possible to mount LED package 150 on circuit board 12 in a state where the inclination of LED package 150 is suppressed.

On the other hand, in the conventional electronic component mounting system, for example, only the solder paste is used without using the adhesive. As described above, if only the solder paste is used without using the adhesive, in reflow furnace 18, when circuit board 12 is heated and the solder paste is melted, LED package 150 is not fixed by the adhesive, so that LED package 150 is inclined with respect to circuit board 12. Specifically, at the height from the upper surface of circuit board 12 to the upper surface of LED package 150, the difference between the maximum height and the minimum height is 74µm. At this time, the upper surface of LED package 150 is inclined by about 1 degree. Thus, if LED package 150 is inclined by about 1 degree, in a case where LED package 150 is used as a light source for vehicle lights, an illumination position of 100m ahead is deviated by as much as 1.7m. Therefore, the inclination of LED package 150 at the time of mounting LED package 150 on circuit board 12 is required to be suppressed as soon as possible.

Therefore, in electronic component mounting system 10, the solder paste is coated to the planned mounting position of LED package 150 on circuit board 12, together with adhesive 160 being also coated thereto, so as to surround center 162 of gravity of LED package 150 in a case of being mounted on circuit board 12. In addition, the curing temperature of the adhesive is lower than the melting point of the solder paste. Therefore, when the solder paste is melted, LED package 150 is fixed by the cured adhesive at four corners surrounding center 162 of gravity. Thus, the inclination of LED package 150 at the time of mounting of LED package 150 on circuit board 12 is suppressed as soon as possible.

Further, as illustrated in Fig. 2, controller 130 has solder coating section 170, adhesive coating section 172, imaging section 173, calculating section 174, mounting section 175, and reflow section 176. Solder coating section 170 is a functional section for coating the solder paste to circuit board 12 by dispenser head 26. Adhesive coating section 172 is a functional section for coating the adhesive to circuit board 12 by dispenser head 28. Imaging section 173 is a functional section for imaging LED package 150 from above. Calculating section 174 is a functional section for calculating deviation amount ΔL of LED element 154 based on the imaging data. Mounting section 175 is a functional section for mounting LED package 150 on circuit board 12 based on deviation amount ΔL of LED element 154. Reflow section 176 is a functional section for heating circuit board 12 by reflow furnace 18.

By the way, in the example described above, electronic component mounting system 10 is an example of a work system. Circuit board 12 is an example of t a board. Work machine 14 is an example of a work machine. Reflow furnace 18 is an example of a reflow device. Control device 19 is an example of a control device. Moving device 24 is an example of a moving device. Dispenser head 26 is an example of a first coating device and a working head. Dispenser head 28 is an example of a second coating device and a working head. Mark cameras 30 and 32 are an example of an imaging device. Mounting heads 76 and 78 are an example of a mounting device. LED package 150 is an example of a surface mount type LED. Further, a step performed by solder coating section 170 is an example of a solder coating step. A step performed by adhesive coating section 172 is an example of an adhesive coating step. A step performed by imaging section 173 is an example of an imaging step. A step performed by calculating section 174 is an example of a calculating step. A step performed by mounting section 175 is an example of a mounting step. A step performed by reflow section 176 is an example of a reflow step.

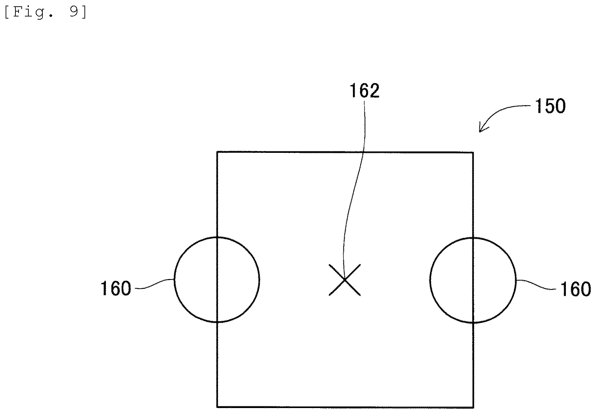

The present invention is not limited to the example described above, and can be implemented in various aspects subjected to various changes and improvements based on the knowledge of those skilled in the art. Specifically, for example, in the examples described above, as illustrated in Fig. 7, adhesive 160 is coated to 4 points so as to surround center 162 of gravity of LED package 150, but as illustrated in Fig. 8, adhesive 160 may, in an illustrative example not falling within the scope of the claimed invention, be coated to 3 points so as to surround center 162 of gravity of LED package 150. Also, as illustrated in Fig. 9, adhesive 160 may , in an illustrative example not falling within the scope of the claimed invention, be coated to 2 points so as to surround center 162 of gravity of LED package 150. However, in a case where adhesive 160 is coated to 2 points, it is preferable that a coating area is increased so as to be coated symmetrically with center 162 of gravity interposed therebetween and to stably hold LED package 150. Further, in another illustrative example not falling within the scope of the claimed invention, adhesive 160 is not coated to multiple points, and may be coatec to only one point by being linearly coated. In other words, adhesive 160 may also be linearly coated so as to surround center 162 of gravity of LED package 150.

Further, in the example described above, the solder paste is coated to circuit board 12 by dispenser head 26, but the solder paste may be coated to circuit board 12 by a screen printer or the like.

Further, in the example described above, LED package 150 is adopted as the surface mount type LED, but LED element 154 may be adopted as the surface mount type LED. In such a case, that is, in a case where LED element 154 is mounted on package board 152 as the surface mount type LED, multiple adhesives are coated to package board 152 so as to surround the center of gravity of the light emitting region of LED element 154. Therefore, before the coating of the adhesive, the light emitting region of LED element 154 is calculated and multiple adhesives are coated to package board 152 so as to surround the center of gravity of the calculated light emitting region.

### Reference Signs List

10: electronic component mounting system (work system), 12: circuit board (board), 14: work machine, 18: reflow furnace (reflow device), 19: control device, 24: moving device, 26: dispenser head (first coating device) (working head), 28: dispenser head (second coating device) (working head), 30: mark camera (imaging device), 76: mounting head (mounting device), 150: LED package (surface mount type LED)

## Claims

1. A component mounting method for mounting a surface mount type LED (150) on a board (12), the method comprising:
a solder coating step of coating a solder paste to the board (12);
an adhesive (160) coating step of coating an adhesive to the board (12) so that an inclination of the surface mount type LED (150) with respect to the board (12), the inclination of which being caused by reflow, is prevented when the surface mount type LED (150) is mounted on the board (12);
an imaging step of imaging, from above, the surface mount type LED (150) before being mounted, so as to acquire imaging data;
a calculating step of calculating a position of a light emitting region of the surface mount type LED (150) based on the imaging data;
a mounting step of mounting the surface mount type LED (150) on the board (12) via the solder paste and the adhesive based on the position of the light emitting region calculated by the calculating step; and
a reflow step of applying the reflow to the board (12), on which the surface mount type LED (150) is mounted,
**characterized in that**
the adhesive is discharged to four corners of the planned mounting position of the surface mount type LED (150), so that amounts of the adhesive are equal to each other, and such as not to overlap with the solder paste

2. The component mounting method according to Claim 1, wherein the adhesive coating step is a step of coating the adhesives to the board (12) such that heights of the adhesives are equal to each other.

3. The component mounting method according to any one of Claims 1 to 2, wherein the surface mount type LED (150) is an LED package (150).

4. The component mounting method according to any one of Claims 1 to 3, wherein a curing temperature of the adhesive is lower than a melting point of the solder paste.

5. The component mounting method according to any one of Claims 1 to 4, wherein in a work machine including two working heads and a moving device (24) for arbitrarily moving each of the two working heads, the solder coating step is a step of coating the solder paste to the board (12) by one working head of the two working heads, and the adhesive coating step is a step of coating the adhesive to the board (12) by the other working head of the two working heads.

6. A work system (10) comprising:
a mounting device configured to mount a surface mount type LED (150) on a board (12);
a first coating device (26) configured to coat a solder paste to the board (12);
a second coating device configured to coat an adhesive (160) to the board (12);
an imaging device (76);
a reflow device (18) configured to apply reflow to the board (12); and
a control device (19),
wherein the control device (19) includes:
a solder coating section configured to coat the solder paste to the board (12)by the first coating device (26),
an adhesive coating section (172) configured to coat the adhesive to the board (12) by the second coating device so that an inclination of the surface mount type LED (150) with respect to the board (12), the inclination of which being caused by the reflow, is prevented when the surface mount type LED (150) is mounted on the board (12),
an imaging section configured to image, by the imaging device (76) from above, the surface mount type LED (150) before mounting, to acquire imaging data,
an calculating section configured to calculate a position of a light emitting region of the surface mount type LED (150) based on the imaging data,
a mounting section configured to mount the surface mount type LED (150) on the board (12) via the solder paste and the adhesive by the mounting device based on the position of the light emitting region calculated by the calculating section, and
a reflow section configured to apply the reflow by the reflow device (18) to the board (12),
on which the surface mount type LED (150) is mounted
**characterized in that**
the adhesive coating section (172) is further configured to discharge the adhesive to four corners of the planned mounting position of the surface mount type LED (150), so that amounts of the adhesive are equal to each other, and such as not to overlap with the solder paste.

## Patentansprüche

1. Bauteilmontageverfahren zur Montage einer oberflächenmontierbaren LED (150) auf einer Platine (12), wobei das Verfahren umfasst:
einen Lötmittelbeschichtungsschritt des Auftragens einer Lötpaste auf die Platine (12);
einen Klebstoffbeschichtungsschritt (160) zum Auftragen eines Klebstoffs auf die Platine (12), so dass eine Neigung der oberflächenmontierten LED (150) in Bezug auf die Platine (12), deren Neigung durch Aufschmelzen verursacht wird, verhindert wird, wenn die oberflächenmontierte LED (150) auf der Platine (12) montiert wird;
einen Abbildungsschritt zum Abbilden der oberflächenmontierten LED (150) von oben, bevor sie montiert wird, um Abbildungsdaten zu erfassen;
einen Berechnungsschritt zum Berechnen einer Position eines lichtemittierenden Bereichs der oberflächenmontierten LED (150) auf der Grundlage der Abbildungsdaten;
einen Montageschritt zum Montieren der oberflächenmontierten LED (150) auf der Platine (12) über die Lötpaste und den Klebstoff auf der Grundlage der durch den Berechnungsschritt berechneten Position des lichtemittierenden Bereichs; und
einen Aufschmelzschritt des Aufschmelzens auf die Platine (12), auf der die oberflächenmontierbare LED (150) montiert ist,
**dadurch gekennzeichnet, dass**
der Klebstoff an vier Ecken der geplanten Montageposition der oberflächenmontierbaren LED (150) aufgebracht wird, so dass die Mengen des Klebstoffs einander gleich sind und sich nicht mit der Lötpaste überlappen.

2. Bauteilmontageverfahren nach Anspruch 1, wobei der Klebstoffbeschichtungsschritt ein Schritt des Auftragens der Klebstoffe auf die Platine (12) ist, so dass die Höhen der Klebstoffe einander gleich sind.

3. Bauteilmontageverfahren nach einem der Ansprüche 1 bis 2, wobei die oberflächenmontierbare LED (150) ein LED-Gehäuse (150) ist.

4. Bauteilmontageverfahren nach einem der Ansprüche 1 bis 3, wobei die Aushärtungstemperatur des Klebstoffs niedriger ist als der Schmelzpunkt der Lötpaste.

5. Bauteilmontageverfahren nach einem der Ansprüche 1 bis 4, wobei in einer Arbeitsmaschine, die zwei Arbeitsköpfe und eine Vorrichtung (24) zum willkürlichen Bewegen jedes der beiden Arbeitsköpfe aufweist, der Lötmittelbeschichtungsschritt ein Schritt des Auftragens der Lötpaste auf die Platine (12) durch einen Arbeitskopf der beiden Arbeitsköpfe ist, und der Klebstoffbeschichtungsschritt ein Schritt des Auftragens des Klebstoffs auf die Platine (12) durch den anderen Arbeitskopf der beiden Arbeitsköpfe ist.

6. Arbeitssystem (10) umfassend:
eine Vorrichtung zur Montage einer oberflächenmontierbaren LED (150) auf einer Platine (12);
eine erste Beschichtungsvorrichtung (26), die so konfiguriert ist, dass sie eine Lötpaste auf die Platine (12) aufträgt;
eine zweite Vorrichtung zum Auftragen eines Klebstoffs (160) auf die Platine (12);
eine Abbildungsvorrichtung (76);
eine Aufschmelzvorrichtung (18), die so konfiguriert ist, dass sie das Aufschmelzen auf die Platine (12) anwendet; und
ein Steuervorrichtung (19),
wobei die Steuervorrichtung (19) umfasst:
einen Lötmittel-Beschichtungsabschnitt, der so konfiguriert ist, dass er die Lötpaste durch die erste Beschichtungsvorrichtung (26) auf die Platine (12) aufbringt,
einen Klebstoffbeschichtungsabschnitt (172), der so konfiguriert ist, dass er den Klebstoff durch die zweite Beschichtungsvorrichtung auf die Platine (12) aufträgt, so dass eine Neigung der oberflächenmontierbaren LED (150) in Bezug auf die Platine (12), deren Neigung durch den Aufschmelzvorgang verursacht wird, verhindert wird, wenn die oberflächenmontierbare LED (150) auf der Platine (12) montiert ist,
einen Abbildungsabschnitt, der so konfiguriert ist, dass er die oberflächenmontierbare LED (150) vor der Montage durch die Abbildungsvorrichtung (76) von oben abbildet, um Abbildungsdaten zu erfassen,
einen Berechnungsabschnitt, der so konfiguriert ist, dass er eine Position eines lichtemittierenden Bereichs der oberflächenmontierten LED (150) auf der Grundlage der Abbildungsdaten berechnet,
einen Montageabschnitt, der so konfiguriert ist, dass er die oberflächenmontierte LED (150) auf der Platine (12) über die Lötpaste und den Klebstoff durch die Vorrichtung für die Montage auf der Grundlage der durch den Berechnungsabschnitt berechneten Position des lichtemittierenden Bereichs montiert, und
einen Aufschmelzabschnitt, der so konfiguriert ist, dass er das Aufschmelzen durch die Aufschmelzvorrichtung (18) auf die Platine (12) anwendet,
auf der die oberflächenmontierbare LED (150) montiert ist
**dadurch gekennzeichnet, dass**
der Klebstoffbeschichtungsabschnitt (172) ferner so konfiguriert ist, dass er den Klebstoff an vier Ecken der geplanten Montageposition der oberflächenmontierbaren LED (150) abgibt, so dass die Mengen des Klebstoffs einander gleich sind und sich nicht mit der Lötpaste überlappen.

## Revendications

1. Procédé de montage de composants pour monter une DEL (150) de type montage en surface sur une carte (12), le procédé comprenant :
une étape d'enduction de pâte à braser sur la carte (12) ;
une étape d'enduction d'adhésif (160) consistant à enduire la carte (12) d'un adhésif afin d'empêcher l'inclinaison de la DEL de type montage en surface (150) par rapport à la carte (12), inclinaison causée par la refusion, lorsque la DEL de type montage en surface (150) est montée sur la carte (12) ;
une étape d'imagerie consistant à imager, par le haut, la DEL de type montage en surface (150) avant qu'elle ne soit montée, afin d'acquérir des données d'imagerie ;
une étape de calcul consistant à calculer la position d'une zone d'émission de lumière de la DEL de type montage en surface (150) sur la base des données d'imagerie ;
une étape de montage de la DEL de type montage en surface (150) sur la carte (12) via la pâte à braser et l'adhésif en fonction de la position de la zone d'émission de lumière calculée par l'étape de calcul ; et
une étape de refusion consistant à appliquer la refusion à la carte (12), sur laquelle la DEL de type montage en surface (150) est montée,
**caractérisé par le fait que**
l'adhésif est déchargé aux quatre coins de la position de montage prévue de la DEL de type montage en surface (150), de manière à ce que les quantités d'adhésif soient égales les unes aux autres et qu'elles ne se chevauchent pas avec la pâte à braser.

2. Procédé de montage de composants selon la revendication 1, dans lequel l'étape d'enduction d'adhésif est une étape d'enduction d'adhésifs sur le panneau (12) de manière à ce que les hauteurs des adhésifs soient égales les unes aux autres.

3. Procédé de montage de composants selon l'une des revendications 1 à 2, dans lequel la DEL de type montage en surface (150) est un boîtier de DEL (150).

4. Procédé de montage de composants selon l'une des revendications 1 à 3, dans lequel la température de durcissement de l'adhésif est inférieure au point de fusion de la pâte à souder.

5. Procédé de montage de composants selon l'une des revendications 1 à 4, dans lequel dans une machine de travail comprenant deux têtes de travail et un dispositif de déplacement (24) pour déplacer arbitrairement chacune des deux têtes de travail, l'étape de revêtement de la soudure est une étape de revêtement de la pâte à souder sur la carte (12) par une tête de travail des deux têtes de travail, et l'étape de revêtement de l'adhésif est une étape de revêtement de l'adhésif sur la carte (12) par l'autre tête de travail des deux têtes de travail.

6. Système de travail (10) comprenant :
un dispositif de montage configuré pour monter une DEL de type montage en surface (150) sur un conseil d'administration (12) ;
un premier dispositif de revêtement (26) configuré pour revêtir la carte (12) d'une pâte à souder ;
un second dispositif de revêtement configuré pour appliquer un adhésif (160) sur le panneau (12) :
un dispositif d'imagerie (76) ;
un dispositif de refusion (18) configuré pour appliquer la refusion à la carte (12); et
un dispositif de contrôle (19),
dans lequel le dispositif de contrôle (19) comprend :
une section d'enduction de soudure configurée pour enduire la pâte à souder sur la carte (12) par le premier dispositif d'enduction (26),
une section d'enduction d'adhésif (172) configurée pour enduire l'adhésif sur la carte (12) par le second dispositif d'enduction de sorte qu'une inclinaison de la DEL de type montage en surface (150) par rapport à la carte (12), dont l'inclinaison est causée par la refusion, est empêchée lorsque la DEL de type montage en surface (150) est montée sur la carte (12), une section d'imagerie configurée pour imager, par le dispositif d'imagerie (76) depuis le haut, la DEL de type montage en surface (150) avant le montage, afin d'acquérir des données d'imagerie, une section de calcul configurée pour calculer une position d'une zone d'émission de lumière de la DEL de type montage en surface (150) sur la base des données d'imagerie,
une section de montage configurée pour monter la DEL de type montage en surface (150) sur la carte (12) via la pâte à braser et l'adhésif par le dispositif de montage sur la base de la position de la zone d'émission de lumière calculée par la section de calcul, et une section de refusion configurée pour appliquer la refusion par le dispositif de refusion (18) à la carte (12),
sur laquelle est montée la DEL de type montage en surface (150)
**caractérisé par le fait que**
la section de revêtement adhésif (172) est en outre configurée pour décharger l'adhésif aux quatre coins de la position de montage prévue de la DEL de type montage en surface (150), de sorte que les quantités d'adhésif soient égales les unes aux autres et qu'elles ne se chevauchent pas avec la pâte à souder.
